# EUROPÄISCHE PATENTSCHRIFT

(11) **EP 0 911 675 B1**
(45) Veröffentlichungstag und Bekanntmachung des Hinweises auf die Patenterteilung: **09.03.2005**
(21) Anmeldenummer: 98117352.9
(22) Anmeldetag: 14.09.1998
(51) Int. Cl.: G02F 1/13

(54) **Einbauverfahren für eine elektrisch kontaktierbare Anzeigeeinrichtung**
Method for mounting an electrically conductable display
Méthode de montage d'un dispositif d'affichage électriquement contacté

(30) Priorität: 25.10.1997 DE 19747288
(43) Veröffentlichungstag der Anmeldung: 28.04.1999
(73) Patentinhaber: ROBERT BOSCH GMBH, 70442 Stuttgart (DE)
(72) Erfinder: Ziegler, Elmar, 71272 Renningen (DE); Borsdorf, Uwe, 71229 Leonberg (DE)

(56) Entgegenhaltungen:
- EP-A- 0 503 427
- PATENT ABSTRACTS OF JAPAN vol. 199, no. 703, 31. März 1997 (1997-03-31) -& JP 08 313880 A (ROHM CO LTD), 29. November 1996 (1996-11-29)
- PATENT ABSTRACTS OF JAPAN vol. 006, no. 265 (P-165), 24. Dezember 1982 (1982-12-24) & JP 57 161722 A (FUJITSU KK), 5. Oktober 1982 (1982-10-05)
- PATENT ABSTRACTS OF JAPAN Bd. 016, Nr. 201 (P-1352) 14 Mai 1992 & JP 04 032 800 A (HITACHI LTD) 04 Februar 1992

## Beschreibung

### STAND DER TECHNIK

Die vorliegende Erfindung betrifft ein Einbauverfahren für eine elektrisch kontaktierbare Anzeigeeinrichtung, insbesondere für eine LCD-Anzeigeeinrichtung bzw. Flüssigkristall-Anzeigeeinrichtung.

Obwohl auf beliebige elektrisch kontaktierbare Anzeigeeinrichtungen anwendbar, werden die vorliegende Erfindung sowie die ihr zugrundeliegende Problematik in bezug auf eine LCD-Anzeigeeinrichtung mit Leitgummikontaktierung von z.B. einer Instrumentenkombination eines Kraftfahrzeuges näher erläutert.

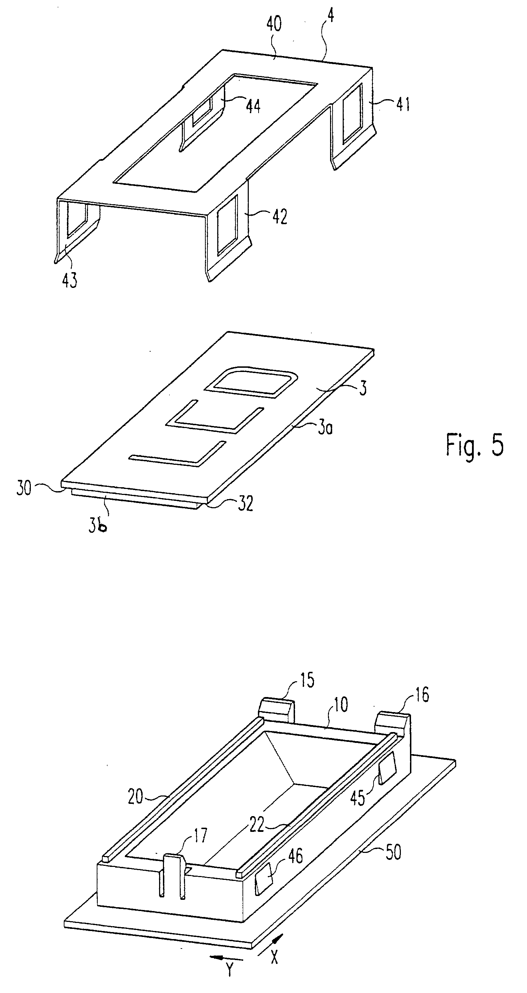

Fig. 5 zeigt eine schematische Darstellung einer bekannten Einbauvorrichtung für eine LCD-Anzeigeeinrichtung.

In Fig. 5 bezeichnet Bezugszeichen 3 die LCD-Anzeigeeinrichtung, welche aus einem oberen rechteckigen Abschnitt 3a und aus einem dazu zurückgesetzten unteren rechteckigen Abschnitt 3b besteht. An der Unterseite des oberen rechteckigen Abschnitts 3a, also im Bereich der so gebildeten Absätze 30 und 32 der LCD-Anzeigeeinrichtung 3, befindet sich eine Reihe von Kontaktflächen bzw. -pads.

Weiterhin bezeichnet Bezugszeichen 10 ein rahmenförmiges rechteckiges Gehäuse, welches auf einer Leiterplatte 50 angebracht ist. Durch die Längswände des Gehäuses 10 sind Leitgummis 20, 22 durch entsprechende Schächte zur Leiterplatte geführt. Diese Leitgummis 20, 22 dienen dazu, die Kontaktflächen im Bereich der Absätze 30 bzw. 32 der LCD-Anzeigeeinrichtung 3 mit entsprechenden Kontaktflächen auf der Leiterplatte 50 zu verbinden.

Um die Schächte des Gehäuses 10 für die Leitgummis 20, 22 genau über den Kontaktflächen der Leiterplatte 50 zu positionieren, wird das Gehäuse mittels Justierstiften zur Leiterplatte 50 ausgerichtet.

Zur Ausrichtung der Kontaktflächen der LCD-Anzeigeeinrichtung 3 zu den Leitgummis 20, 22 weist das Gehäuse zwei Anschläge 15, 16 an seiner hinteren Schmalseite und eine Federnase 17 an seiner vorderen Schmalseite auf.

Bezugszeichen 4 bezeichnet einen Halterahmen, welcher eine rechteckige Oberseite 40 und vier davon senkrecht abgewinkelte Einhänglaschen 41 - 44 aufweist. Über den Halterahmen 4, der in entsprechenden Rastnasen 45, 46 an der vorderen Außenseite und entsprechenden nicht gezeigten Rastnasen an der hinteren Außenseite des Gehäuses 10 einrastet, wird die LCD-Anzeigeeinrichtung 3 in vertikaler Richtung auf die Leitgummis 20, 22 gepreßt und so eine stabile Kontaktierung zur Leiterplatte 50 ermöglicht.

Die x-y-Position der LCD-Anzeigeeinrichtung 3 parallel zur Leiterplatte 50 wird bei der in Fig. 5 gezeigten Anordnung über das Gehäuse 10 erzeugt. Hierzu ist das Gehäuse 10 mittels der erwähnten Justierstifte zur Leiterplatte 50 ausgerichtet und daran befestigt. Weiterhin sind die zwei Anschläge 15, 16 an seiner hinteren Schmalseite und die Federnase 17 an seiner vorderen Schmalseite maßgenau gefertigt.

Die Montagereihenfolge der bekannten Einbauvorrichtung stellt sich also folgendermaßen dar:
- Anbringen des Gehäuses 10 an der Leiterplatte 50;
- Einlegen der Leitgummis 20, 22 in die Schächte des Gehäuses 10;
- Öffnen der Federnase 17 und Einlegen der LCD-Anzeigeeinrichtung 3; und
- Fügen und Verrasten des Halterahmens 4.

Als nachteilhaft bei der obigen bekannten Einbauvorrichtung für eine LCD-Anzeigeeinrichtung hat sich die Tatsache herausgestellt, daß das Glas der LCD-Anzeigeeinrichtung mit dem Gehäuse 10 und dem Halterahmen 4 in Kontakt kommt und dabei ein Materialabrieb am Gehäuse auftritt. Außerdem sind die Anschläge 15, 16 und die Federnase 17 genau so hoch oder sogar höher als die entspannten Leitgummis 20, 22, da die LCD-Anzeigeeinrichtung vor dem vertikalen Niederdrücken und Verrasten des Halterahmens 4 ja zuerst ausgerichtet werden muss. Diese vorstehenden Anschläge 15, 16 und Federnase 17 sind aus Platzgründen und Designaspekten störend. Oftmals muss deshalb sogar die rechteckige Oberseite 40 des Halterahmens 4 entsprechende Durchbrüche aufweisen und verliert deshalb an Stabilität.

Aus der EP 503427 A2 ist ein Gehäuse mit einer Halterung für eine Flüssigkristallanzeige bekannt, bei der die Flüssigkristallanzeige in einem Träger gehalten wird. Durch den Träger hindurch kontaktiert die Flüssigkristallanzeige mit einem Leitgummi eine Leiterplatte. Der Träger und die Flüssigkristallanzeige werden von einem Gehäusedeckel abgedeckt.

Aus der JP 08313880 - Abstract ist ein Metallrahmen zum Halten einer Flüssigkristallanzeige bekannt, bei der elastische Blätter zwischen der Flüssigkristallanzeige und dem Metallrahmen angeordnet sind.

Aus der JP 57-161722 - Abstract ist eine Flüssigkristallanzeige bekannt, bei der eine Abdeckung die Flüssigkristallanzeige über Leitgummis gegen eine Leiterplatte drückt. Hierbei ist zwischen der Flüssigkristallanzeige und der Abdeckung ein klebendes Band angeordnet.

### Vorteile der Erfindung

Das erfindungsgemäße Einbauverfahren für eine elektrisch kontaktierbare Anzeigeeinrichtung mit den Merkmalen des Anspruchs 1 weisen gegenüber dem bekannten Lösungsansatz den Vorteil auf, dass eine genauere Positionierung der Anzeigeeinrichtung bezüglich der Leiterplatteneinrichtung möglich ist und dass der Einbau vereinfacht wird. Dies gilt insbesondere dann, wenn die Halterahmeneinrichtung ein metallisches Stanzbiegeteil ist, das sehr präzise herstellbar ist. Die Abdeckscheibe der Anzeigeeinrichtung kommt nicht mit der Gehäuseeinrichtung in Kontakt, so dass es keinerlei Antrieb von Materialspänen gibt. Die Oberfläche lässt sich eben gestalten ohne störende nach oben weisende Nasen, wie beim bekannten Ansatz.

Die der vorliegenden Erfindung zugrundeliegende Idee besteht darin, dass beim Einbauverfahren das Gehäuse keine Ausrichtfunktion mehr ausübt, sondern diese durch den Halterahmen und die Leiterplatte übernommen wird. Das Gehäuse dient nur noch zur Aufnahme der elektrischen Verbiridungskörpereinrichtung sowie einer möglichen LCD-Beleuchtungseinrichtung und kann Bestandteil eines größeren Bauteils, z.B. eines Reflektors, der bei solchen Anzeigeeinrichtungen üblich ist, sein. Die Fixierung in vertikaler Richtung und in x-y-Richtung und damit die einwandfreie Kontaktierung der LCD-Anzeigeeinrichtung wird von der Halterahmeneinrichtung gewährleistet.

In den Unteransprüchen finden sich vorteilhafte Weiterbildungen und Verbesserungen des in Anspruch 1 angegebenen Einbauverfahrens für eine Anzeigeeinrichtung.

Gemäß einer bevorzugten Weiterbildung weist die elektrische Verbindungskörpereinrichtung einen Leitgummi auf. Dieser Leitgummi muß aufgrund der besseren Orientierung keinen sehr feinen Pitch (Musterdimension) aufweisen.

Gemäß einer weiteren bevorzugten Weiterbildung weist der Leitgummi, der erste und der zweite Kontaktbereich eine entsprechende Strukturierung auf.

Gemäß einer weiteren bevorzugten Weiterbildung ist die Strukturierung eine Streifenstruktur mit abwechselnd leitenden und nicht-leitenden Bereichen in Längsrichtung der Kontaktbereiche.

Gemäß einer weiteren bevorzugten Weiterbildung sind die leitenden Streifen des Leitgummis schmaler als die leitenden Streifen des ersten und zweiten Kontaktbereichs.

Gemäß einer weiteren bevorzugten Weiterbildung weist die Verbindungseinrichtung eine Adhäsionseinrichtung, insbesondere eine zwischen der Anzeigeeinrichtung und der Halterahmeneinrichtung anbringbare Klebschicht, auf.

Gemäß einer weiteren bevorzugten Weiterbildung weist die Verbindungseinrichtung eine Klebfolie auf, die derart an der Anzeigeeinrichtung und der Halterahmeneinrichtung anbringbar ist, daß sie, wenn die Gehäuseeinrichtung und die Halterahmeneinrichtung mit der Anzeigeeinrichtung an der Leiterplatteneinrichtung angebracht sind, abziehbar ist. Dadurch kann die Klebfolie nach der Montage entfernt werden.

Gemäß einer weiteren bevorzugten Weiterbildung ist die Klebfolie auf der Vorderseite der Anzeigeeinrichtung als Schutzfolie anbringbar. Hierdurch erfüllt die Klebfolie eine Doppelfunktion, denn sie gewährleistet einerseits die korrekte Ausrichtung von Anzeigeeinrichtung und Halterahmeneinrichtung und andererseits den Schutz der Abdeckscheibe der Anzeigeeinrichtung während Transport und/oder Lagerung.

Gemäß einer weiteren bevorzugten Weiterbildung weist die Halterahmeneinrichtung eine rechteckige Oberseite und davon im wesentlichen senkrecht nach unten abgewinkelte Einhänglaschen auf.

Gemäß einer weiteren bevorzugten Weiterbildung ist die Halterahmeneinrichtung ein metallisches Stanzbiegeteil. Solch ein Teil ist kostengünstig und präzise herstellbar.

Gemäß einer weiteren bevorzugten Weiterbildung weist die Halterahmeneinrichtung Anschläge zur Orientierung der Anzeigeeinrichtung auf. Dies ermöglicht eine genaue Ausrichtung der Anzeigeeinrichtung zum Zusammenbau.

Gemäß einer weiteren bevorzugten Weiterbildung weist die Leiterplatteneinrichtung Durchbrüche mit Halteblöcken zum Einhängen der Einhänglaschen der Halterahmeneinrichtung auf.

Gemäß einer weiteren bevorzugten Weiterbildung weist die Gehäuseeinrichtung eine plattenförmige Gestalt mit einem Durchbruch für die Anzeigeeinrichtung, zwei längsseitig des Durchbruchs gegenüberliegenden Schächten für die elektrische Verbindungskörpereinrichtung und zwei parallel dazu verlaufenden Schächten für die Halterahmeneinrichtung auf. So kann das Gehäuse Bestandteil eines größeren Funktionblocks sein, beispielsweise eines Reflektors.

Gemäß einer weiteren bevorzugten Weiterbildung weisen die Schächte für die Halterahmeneinrichtung nach außen weisende Aussparungen auf. Damit ist ein problemloses Aufbiegen der Einhänglaschen möglich.

### ZEICHNUNGEN

Erfindungsgemäß hergestelle Ausführungsbeispiele sind in den Zeichnungen dargestellt und in der nachfolgenden Beschreibung näher erläutert.

Es zeigen:
- Fig. 1: eine schematische Darstellung einer ersten Ausführungsform der erfindungsgemäß hergestellten Einbauvorrichtung für eine LCD-Anzeigeeinrichtung;
- Fig. 2: eine Darstellung der mit der Halterahmeneinrichtung verbundenen LCD-Anzeigeeinrichtung gemäß einer zweiten erfindungsgemäß hergestellten Ausführungsform;
- Fig. 3: eine Darstellung der mit der Halterahmeneinrichtung verbundenen LCD-Anzeigeeinrichtung gemäß einer dritten erfindungsgemäß hergestellten Ausführungsform;
- Fig. 4: eine Darstellung der mit der Halterahmeneinrichtung verbundenen LCD-Anzeigeeinrichtung gemäß einer vierten erfindungsgemäß hergestellten Ausführungsform; und
- Fig. 5: eine schematische Darstellung einer bekannten Einbauvorrichtung für eine LCD-Anzeigeeinrichtung.

### BESCHREIBUNG DER ERFINDUNGSGEMÄß HERGESTELLTEN AUSFÜHRUNGSBEISPIELE

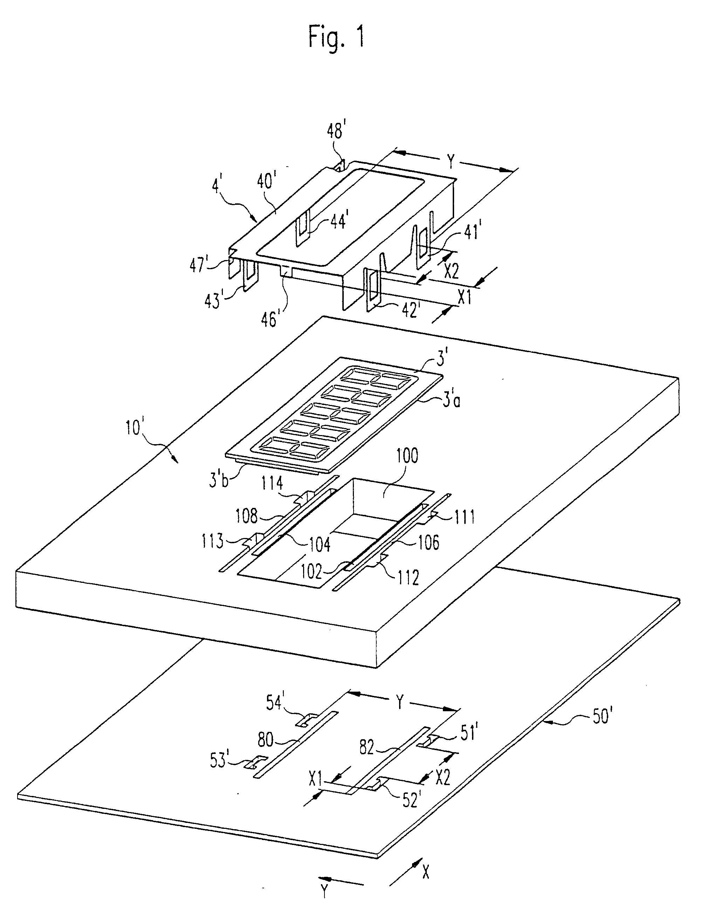

Fig. 1 illustriert eine schematische Darstellung einer erster erfindungsgemäß hergestellten Ausführungsform der Einbauvorrichtung für eine LCD-Anzeigeeinrichtung.

In Fig. 1 bezeichnet 3' eine LCD-Anzeigeeinrichtung, welche der oben beschriebenen bekannten LCD-Anzeigeeinrichtung entspricht.

4' bezeichnet eine Halterahmeneinrichtung mit einer rechteckigen Oberseite 40' und vier davon senkrecht abgewinkelten Einhänglaschen 41' - 44'. 46', 47' und 48' sind Anschläge zum genauen Positionieren der LCD-Anzeigevorrichtung 3' in der Halterahmeneinrichtung 4'. Die Halterahmeneinrichtung 4' ist ein Präzisionsteil, zweckmäßigerweise ein Stanzbiegeteil aus Metall, mit entsprechend den Kontakttoleranzen genau festgelegten Abständen X1, X2 und Y.

50' bezeichnet eine Leiterplatteneinrichtung mit in Längsrichtung strukturierten Kontaktstreifen (80, 82), welche ein (nicht-dargestelltes) Zebrastreifenmuster" aus leitenden und nicht-leitenden Bereichen in Längsrichtung aufweisen. Das entsprechende Muster findet sich in der elektrischen Verbindungskörpereinrichtung und an der Unterseite der LCD-Anzeigeeinrichtung 3'. Weiterhin weist die Leiterplatteneinrichtung 50' vier Durchbrüche 51' - 54' mit Halteblöcken zum Einhängen der Einhänglaschen 41' - 44' der Halterahmeneinrichtung (4') auf. Die Durchbrüche 51' - 54' in der Leiterplatteneinrichtung 50' sind maßgenau (vgl. Maße X1, X2 und Y) zu den Kontaktstreifen 80, 82, so daß bei Verrasten der Einhänglaschen 41' - 44' in den Halteblöcken der Durchbrüche 51' - 54' die Kontaktstreifen auf der Unterseite der LCD-Anzeigeeinrichtung 3' im wesentlichen genau über den Kontaktstreifen 80, 82 der Leiterplatteneinrichtung 50' liegen. Daher sind die Durchbrüche 51' - 54' zweckmäßigerweise durch Stanzen hergestellt.

Die Gehäuseeinrichtung 10' hat eine plattenförmige Gestalt mit einem Durchbruch 100 für die LCD-Anzeigeeinrichtung 3', welcher einen kleineren Querschnitt als der obere rechtekkige Abschnitt 3'a und einen größeren Querschnitt als der dazu zurückgesetzte untere rechteckige Abschnitt 3'b aufweist. Längsseitig des Durchbruchs 100 liegen jeweils ein Schacht 102 bzw. 104 für die elektrische Verbindungskörpereinrichtung, welche im gezeigten Beispiel ein Leitgummi ist. Parallel dazu verlaufen jeweils ein Schacht 106 bzw. 108 für die Seiten der Halterahmeneinrichtung 4'. Die Schächte 106, 108 für die Seiten der Halterahmeneinrichtung 4' weisen nach außen weisende Aussparungen 111 - 114 auf, welche ein Aufbiegen der Einhänglaschen zum Verrasten mit .den Halteblöcken der Durchbrüche 51'- 54' ermöglichen.

Die Montagereihenfolge der erfindungsgemäß hergestellten, ersten Ausführungsform der Einbauvorrichtung läuft folgendermaßen ab.

Die Gehäuseeinrichtung 10' wird zunächst an der Leiterplatteneinrichtung 50' derart angebracht, daß die Schächte 102, 104 zu den Kontaktstreifen 80, 82 hinreichend genau orientiert sind. Dann werden die Leitgummis in die Schächte 102, 104 der Gehäuseeinrichtung 10' eingeführt.

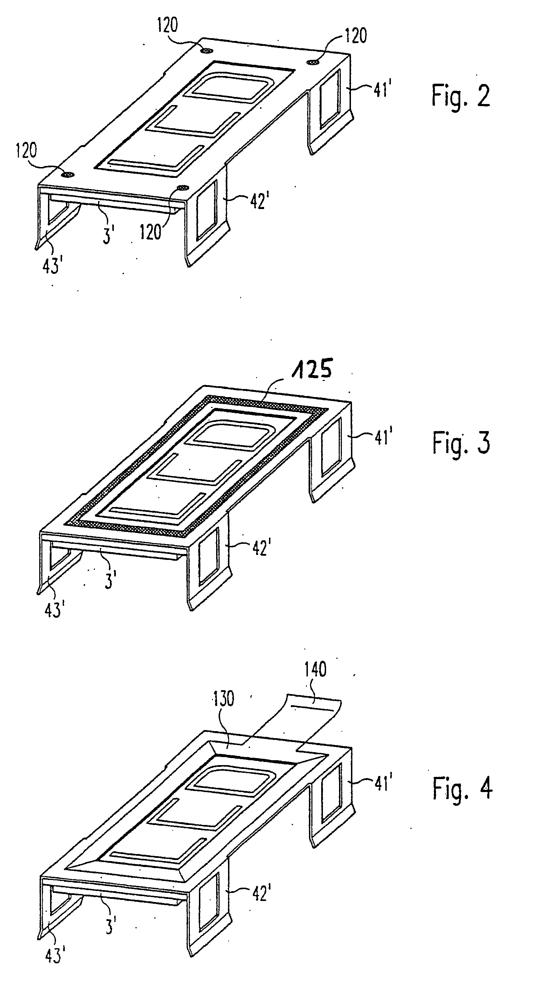

Fig. 2 zeigt eine Darstellung der mit der Halterahmeneinrichtung verbundenen LCD-Anzeigeeinrichtung gemäß einer erfindungsgemäß hergestellten zweiten Ausführungsform.

Bei der erfindungsgemäß hergestellten zweiten Ausführungsform wird die Verbindung zwischen der LCD-Anzeigeeinrichtung 3' und der Halterahmeneinrichtung 4' mittels einer punktförmig auf die LCD-Anzeigeeinrichtung und/oder die Halterahmeneinrichtung aufgebrachten Adhäsionsschicht 120, z.B. Klebstoff, realisiert.

Damit muß die Oberfläche der LCD-Anzeigeeinrichtung nicht von einem Greifer berührt werden, und daher ist das Risiko einer Verschmutzung oder Beschädigung dieser Oberfläche weiter verringert. Der Betrachter nimmt die Adhäsionsschicht 120 nicht wahr, da sie in verdeckten Bereich zwischen LCD-Anzeigeeinrichtung 3' und Halterahmen 4' liegt.

Fig. 3 zeigt eine Darstellung der mit der Halterahmeneinrichtung verbundenen LCD-Anzeigeeinrichtung gemäß einer erfindungsgemäß hergestellten dritten Ausführungsform.

Bei der erfindungsgemäß hergestellten, dritten Ausführungsform wird die Verbindung zwischen der LCD-Anzeigeeinrichtung 3' und der Halterahmeneinrichtung 4' mittels einer streifenförmig auf die LCD-Anzeigeeinrichtung 3' und/oder die Halterahmeneinrichtung 4' aufgebrachten Adhäsionsschicht 125, z.B. Klebstoff, realisiert.

Damit ergeben sich dieselben Vorteile wie bei der erfindungsgemäß hergestellten, zweiten Ausführungsform und darüber hinaus noch einer stabilere Verbindung zwischen der LCD-Anzeigeeinrichtung 3' und der Halterahmeneinrichtung 4'.

Fig. 4 zeigt eine Darstellung der mit der Halterahmeneinrichtung verbundenen LCD-Anzeigeeinrichtung gemäß einer erfindungsgemäß hergestellten, vierten Ausführungsform.

In Fig. 4 bezeichnet 130 eine Klebfolie und 140 eine davon ausgehende Abziehlasche.

Bei der erfindungsgemäß hergestellten, vierten Ausführungsform wird die Verbindung zwischen der LCD-Anzeigeeinrichtung 3' und der Halterahmeneinrichtung 4' mittels der Klebfolie 130 realisiert. Die Klebfolie schützt gleichzeitig die Abdeckscheibe der LCD-Anzeigeeinrichtung 3' und braucht erst bei Inbetriebnahme derselben entfernt zu werden.

Obwohl die vorliegende Erfindung anhand eines bevorzugten, erfindungsgemäß hergestellten Ausführungsbeispiels vorstehend beschrieben wurde, ist sie darauf nicht beschränkt, sondern auf vielfältige Weise modifizierbar.

Insbesondere kann in den erfindungsgemäß hergestellten Ausführungsformen die Gehäuseeinrichtung eine beliebige Form annehmen, solange sie die Stabilisierung der Leitgummis bewirkt. Dementsprechend könnten die Schächte 106 und 108 entfallen.

Auch muß der Durchbruch 100 nicht bis zur Leiterplatteneinrichtung 50' durchgehen, sondern kann auch aus einer Absenkung bstehen.

Auch sind die Anschläge 46', 47', 48' nicht zwingend notwendig, und eine gegenseitge Orientierung kann auch mit einer optischen Justiervorrichtung erreicht werden, bevor die Anzeigeeinrichtung und die Halterahmeneinrichtung miteinander verbunden werden.

## Patentansprüche

1. Verfahren zum Einbau einer elektrisch kontaktierbaren Anzeigeeinrichtung (3'), insbesondere einer Flussigkristall-Anzeigeeinrichtung, in eine Montagebaugruppe bestehend aus Gehäuseeinrichtung (10'), Leiterplatteneinrichtung (50'), Halterahmeneinrichtung (4') und elektrischer Verbindungskörpereinrichtung mit folgenden Schritten:
a) Befestigen der Gehäuseeinrichtung (10') an der Leiterplatteneinrichtung (50');
b) Verbinden der Anzeigeeinrichtung (3') und der Halterahmeneinrichtung (4') mittels einer Adhäsionsschicht oder einer Klebefolie (120; 125; 130, 140);
c) Durchführen der elektrischen Verbindungskörpereinrichtung durch die Gehäuseeinrichtung (10');
d) Befestigen der Halterahmeneinrichtung (4') mit der damit verbundenen Anzeigeeinrichtung (3') an der Leiterplatteneinrichtung, an welcher die Gehäuseeinrichtung (10') befestigt ist.

2. Verfahren nach Anspruch 1, **gekennzeichnet durch** den Schritt des Entfernens der Klebefolie (130; 140) nach Schritt d).

## Claims

1. Method for installing a display device (3') with which electrical contact can be made, in particular a liquid-crystal display device, in a mounting assembly comprising a housing device (10'), a printed circuit board device (50'), a retaining frame device (4') and an electrical connecting body device, having the following steps:
a) fixing the housing device (10') to the printed circuit board device (50');
b) connecting the display device (3') and the retaining frame device (4') by means of an adhesive layer or an adhesive film (120; 125; 130, 140);
c) passing the electrical connecting body device through the housing device (10'); and
d) fixing the retaining frame device (4') having the display device (3') associated therewith to the printed circuit board device, to which the housing device (10') is fixed.

2. Method according to Claim 1, **characterized by** the step of removing the adhesive film (130; 140) following step d).

## Revendications

1. Procédé de montage d'un dispositif d'affichage électriquement contacté (3'), notamment d'un dispositif d'affichage à cristaux liquides, dans un bloc de montage composé d'un dispositif de boîtier (10'), d'un dispositif de plaquette de circuit imprimé (50'), d'un dispositif de serre-flan (4') et d'un dispositif de corps de connexion électrique,
**caractérisé par**
les étapes suivantes :
a) fixation du dispositif de boîtier (10') au dispositif de plaquette de circuit imprimé (50'),
b) liaison du dispositif d'affichage (3') et du dispositif de serre-flan (4') au moyen d'une couche adhésive ou d'un film adhésif (120, 125, 130, 140),
c) passage du corps de connexion électrique à travers le dispositif de boîtier (10'), et
d) fixation du dispositif de serre-flan (4'), avec le dispositif d'affichage (4') qui y est relié, au dispositif de plaquette de circuit imprimé, auquel est fixé le dispositif de boîtier (10').

2. Procédé selon la revendication 1,
**caractérisé par**
une étape de suppression du film adhésif (130, 140) après l'étape d).
